# EUROPEAN PATENT SPECIFICATION

(11) **EP 2 018 504 B1**
(45) Date of publication and mention of the grant of the patent: **29.03.2017**
(21) Application number: 07735347.2
(22) Date of filing: 30.03.2007
(51) Int. Cl.: H02S 20/26, H02S 20/30, F24J 2/38, F24J 2/54

(54) **MODULAR MULTIFUNCTIONAL SOLAR STRUCTURE (MMSS)**
MODULARE UND MULTIFUNKTIONELLE SOLAR-STRUKTUR (MMSS)
STRUCTURE SOLAIRE MULTIFONCTIONNELLE MODULAIRE (MMSS)

(30) Priority: 12.05.2006 PT 10347906
(43) Date of publication of application: 28.01.2009
(73) Proprietor: Jerónimo Lopes, Amílcar Luís, P-2400-823 Leiria (PT)
(72) Inventor: Jerónimo Lopes, Amílcar Luís, P-2400-823 Leiria (PT)
(74) Representative: Ferreira, Maria Silvina
(86) International application number: PCT/IB2007/051158
(87) International publication number: WO 2007/132363

(56) References cited:
- EP-A- 1 632 786
- WO-A-2005/090873
- DE-A1- 10 149 620
- FR-A- 2 779 275
- GB-A- 2 392 556
- JP-A- 2005 090 889
- US-A- 4 114 594
- US-A- 4 198 955
- US-A- 4 365 617
- US-A- 4 432 343
- US-A- 4 469 938
- US-A- 6 029 656
- US-A1- 2002 189 662
- WENHAM S R ET AL: "Low cost photovoltaic roof tile" SOLAR ENERGY MATERIALS AND SOLAR CELLS, ELSEVIER SCIENCE PUBLISHERS, AMSTERDAM, NL, vol. 47, no. 1-4, October 1997 (1997-10), pages 325-337, XP004099654 ISSN: 0927-0248

## Description

The Modular Multifunctional Solar Structure is an innovative design in the field of Renewable h.nergy, This system will collect the energy from the sunlight and will resolve the following problems experienced with existing solar energy collectors:
- A fixed position, which is confined to specific angles, or a vertical layout, both of which are inefficient in terms of energy recovery.
- Large dimensions and heavyweight collectors, which may need ungainly support structures
- Wasted space
- Difficult to integrated as an architectural element in building design

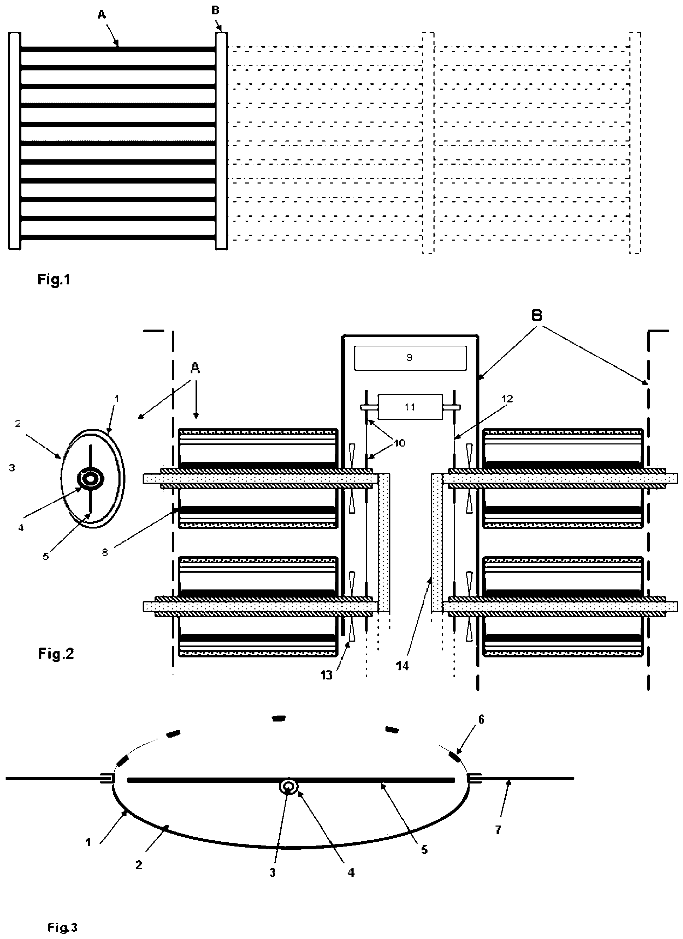

The Solar Structure (Fig 1 & 2) comprises a (variable) number of thermal or photovoltaic receiving elements (A) and support columns which house the technical services (B). With simple, progressive assembly this Solar Structure can be adapted to perform the following functions in addition to the primary function of thermal and / or photovoltaic energy recovery:
- Provide shading to buildings, windows, parking areas etc.
- Used in its tile function, the covering of gardens, passageways or other spaces.

The receivers can be mounted in fixed positions or with a mechanism designed to track the sun with azimuth or latitudinal positioning. It can be operated manually or fully automatically by microprocessor control in order to maximize energy collection. These qualities permit the Solar Structure to be installed with positive or negative angles, horizontally or even vertically, in any place exposed to the sun - for instance over balconies, patios, terraces, roves (even North facing ones), walls and dividers. In fact, installation in the vertical position even allows the units to be used instead of safety fences in areas such as balconies etc. This flexibility even allows the recuperation of solar energy in apartment blocks and office buildings.

### Background art

The prior art in solar collectors, as far as architectonic building integration is concerned, suffers from an important drawback: serious problems in architectonic integration capability. Due to this reason, most potential users, and architects in particular, have not adhered to these solutions. This is the reason why both thermal and photovoltaic solar collectors have been mostly confined to rooftop applications.
The existing solutions have such shortcomings in terms of architectural integration that, in the field of the photovoltaic energy collection, flat-plate panels have even been directly applied to vertical building surfaces, in spite of efficiency problems due to the sun being misaligned to the strictly vertical positions.
In order to supply sustainable energy from the sun and substantially increase its use with full architectonic integration, it is necessary to find new solutions to turn available more and more space on buildings (façades, balconies, over windows, etc.) and also on external spaces to collect such energy. If possible these solutions should be extended to the development of construction elements with active solar energy capabilities.
Whatsoever be the solution, it has to be architecturally integrated, efficient and easily deployed in building surfaces.
It will be shown how the present invention differs from the prior art in order to attain these goals.

The present invention focuses on providing a complete solution to these difficulties and it will be shown how a simple individual collector cannot be the answer to these. Instead, a new approach is required, embodied in the present invention by a new and comprehensive Structure of individual solar collectors of thermal, photovoltaic or both types.
The present invention provides means for bearing said collectors in new Support Columns, fundamental for interconnecting modules or groups of solar collectors while at the same time containing away from exterior view all necessary support components.
The present invention also encases individual collectors in elliptical elements able to cover and bear them, while at the same time providing means for terminating this new collector arrangement with adequate mechanical and thermal traits.
In order to achieve modularity, ease of deployment and architectural integration the interconnections of individual solar collectors are as important as the collectors themselves. The present invention, contrary to the prior art, identifies specific and detailed means for these.
Because of these unique features, the present invention can achieve Multifunction capabilities by being able to provide shadow and enclosure, further extended by the means of a special multifunction blade (7).

Document WO 2005/090873 (subsequently referred as D1) discloses a solar energy collector based on a linear concentrator with a raised absorber and transparent covering, providing reflectors, re-reflectors and the possibility of using simultaneously thermal and photovoltaic elements. D1 also discloses a specific structure for the absorber structure which combines two releasable connected absorbers. D1 does not disclose specific means for supporting and connecting said linear concentrator at each extremity. D1 describes a fundamentally different absorber structure when compared to the present invention. D1 does not disclose the present invention Support Columns or any technical feature essential for multifunction facilities.

D1, on the whole, describes an individual solar collector and never discloses adequate technical features for aggregating said collectors into a complete workable solar collecting structure, like the present invention does by means of the said support columns.

In fact, D1 implies a different problem-solution than that of the present invention. D1 focuses on providing a highly effective solar to thermal and/or electrical conversion rate at the cost of other also important and relevant aims, namely modularity, low complexity, low part-count, flexibility in deployment, low building profile and therefore cost of producing, assembling and mounting said collectors. The present invention focuses on providing a highly flexible, modular, easily mounted, relatively simple, cost-effective solar collector at possibly the cost of a lower thermal and/or electrical conversion rate. These differences in terms of problem-solution, irremediably preclude similar technical features for the present invention and D1, the inventions being different in nature, structure and purpose, as will be shown below.

D1 essentially discloses a collector based on a reflector, whereas the present invention does not make use of a reflector. This reflector is paramount to D1, as without it, D1 does not describe a feasible solution, given that the disclosed direct absorption is secondary and optional. Reflectors are relatively more complex and costlier parts than what is proposed by the present invention. The present invention does not use a reflector, instead makes full use of direct solar absorption.

D1 discloses a structure which can have a sunshade or tile function, but only as so far as it is inherent to any structure able to reflects or absorb solar energy. Shade, by definition, is caused by any material that reflects or absorbs light. In fact, D1 has no specific technical features relevant to this purpose. The present invention discloses specific linear side structures, extremity terminations, thermal sleeves (e) and gaskets (f), cushions (b) and couplings (a) which are necessary to achieve modularity and rotational capability essential for creating an effective shading or tiling system. Furthermore, the present invention describes a specific blade format (7) critical to creating a fully shaded or tile-enclosed area, ensuring full overlap and interconnection between collectors. Without this feature, D1 only provides a partial shading/tiling solution, even if, as previously mentioned, it is also a costlier, heavier, more complex and a much higher part-count solution.

D1 does reveal the need for adequate support structures but does not disclose any significant feature of these. The present invention describes a Support Column fully integrated architectonically, independent from the collectors, to fix them and simultaneously to house and to preserve from outside view the technical services (electronic and mechanical systems, wirings, pipes, sensors etc.). The present invention details linear support columns (B) which provide for modularity and ease of deployment of multiple collectors jointly connected by said support columns (B).

D1 discloses a pipe for carrying the thermal fluid out of the collector but, as disclosed, this pipe has no structural weight bearing purpose, whereas in the present invention it plays a key part in both the structure and the function of the collector. In the present invention, this pipe (4) is centrally located and serves both as a structural weight carrying element as a means for carrying thermal fluid, through a second pipe (3), or electric connections.

As previously referred, the need for simple and effective terminations for the collector creates an additional challenge. D1 does not disclose any specific cushions or gaskets; it merely mentions they are required, these being absolutely essential for obtaining a working system. D1 does disclose a termination device but it merely states the possibility of reflowing thermal fluid between the two pipes. The present invention discloses a full working design, able to resolve the issues with the centrally placed weight bearing pipe (4), providing extremity terminations, comprised of thermal sleeves (e) and gaskets (f), cushions (b) and couplings (a), enabling the flow of thermal fluid or passage of electric connections, while at the same time bearing the weight of the collector.

The present invention uses elliptical transparent tubes (2). D1 describes partially elliptical reflectors, which by nature cannot be transparent if they are to provide effective reflection. D1 uses elliptical reflectors as this is obviously the correct shape for reflecting as much solar energy as possible. D1 cover transparent elements are in reality flat, with no provision for any other format. The present invention makes use of the elliptical shape as to provide an effective transparent cover for the absorber surface, while at the same time providing for adequate structural bearing for the collector. The elliptically shaped elements in D1 and the present invention are used for different functions, are different in their materials and the actual shape is used with different purposes.

Furthermore, the proposed absorber in D1 cannot achieve the shading and/or tiling effect provided by the blade (7) of the present invention. D1 can only achieve a partial shade/tile solution, albeit a costlier and more complex, through the use of its reflector surfaces, this inherently being dissimilar to the present invention.

As shown above, D1 describes a fundamentally different collector and support structure. The present invention provides elliptic transparent tubes housing individual collectors with effective side terminations and support structures. These features enable smaller and lighter collectors, facilitating installation and architectural acceptance, providing an effective shading and/or tile function, while allowing the substitution of construction elements (e.g. balconies safeguards). The present invention further allows straightforward progressive installation of collector modules and simple replacement of individual collectors.

Document US 6 029 656 (subsequently referred as D2) discloses a solar energy collector based on a linear concentrator with a centred absorber and transparent covering, providing parabolic reflectors and the possibility of using simultaneously thermal and photovoltaic elements. Although there is a plurality of heat collectors, they are all disposed inside a flat housing, as D2 refers to a glazed flat-plate type collector. D2 also discloses a specific structure for the reflector structure which combines two parabolic reflectors. D2 does not disclose specific means for supporting and connecting said linear concentrator at each extremity. D2 does not disclose the present invention Support Columns or any technical feature essential for multifunction facilities.

In fact, D2 implies a different problem-solution than that of the present invention. D2 focuses on providing a highly effective solar to thermal and/or electrical conversion rate at the cost of other also important and relevant aims, namely modularity, low complexity, low part-count, flexibility in deployment, low building profile and therefore cost of producing, assembling and mounting said collectors. The present invention focuses on providing a highly flexible, modular, easily mounted, relatively simple, cost-effective solar collector at possibly the cost of a lower thermal and/or electrical conversion rate. These differences in terms of problem-solution, irremediably preclude similar technical features for the present invention and D2, the inventions being different in nature, structure and purpose, as will be shown below.

D2 essentially describes an individual solar collector and although it presents said individual collectors in sets, it never discloses adequate technical features for aggregating said collectors into a complete workable solar collecting structure, like the present invention does by means of the said support columns.

D2 essentially discloses a collector based on a double reflector, whereas the present invention does not make use of a reflector. This reflector is paramount to D2, as without it, D2 does not describe a feasible solution, given that the disclosed direct absorption is secondary as compared to the direct absorption. Reflectors are relatively more complex and costlier parts than what is proposed by the present invention. The present invention does not use a reflector, instead makes full use of direct solar absorption.

D2 discloses a structure which can have a sunshade or tile function, but only as so far as it is inherent to any structure able to reflect or absorb solar energy. Shade, by definition, is caused by any material that reflects or absorbs light. In fact, D2 has no specific technical features relevant to this purpose as it will be shown. One could envision D2 as generating a shade solution, albeit a partial one (as will also be shown further below), but this would always imply using the disclosed transparent cover outside the full area meant for the shading or tiling effect. This is neither practical nor thermally effective for large areas, e.g. outside building walls. The present invention discloses specific linear side structures, extremity terminations, thermal sleeves (e) and gaskets (f), cushions (b) and couplings (a) which are necessary to achieve modularity and rotational capability essential for creating an effective shading or tiling system, while providing enclosure for each individual collector. This individual enclosure creates additional challenges for the terminations of the collectors, challenges resolved by the disclosed extremity terminations. Furthermore, the present invention describes a specific blade format (7) critical to creating a fully shaded or tile-enclosed area, ensuring full overlap and interconnection between collectors. Without this feature, D2 can only provide complete shading by means of using of its full housing, which is not only impractical due to the size and complexity, but is also permanent not providing means for controlling the shading effect.

D2 does reveal the need for adequate support structures but does not disclose any significant feature of these. The present invention describes a Support Column fully integrated architectonically, independent from the collectors, to fix them and simultaneously to house and to preserve from outside view the technical services (electronic and mechanical systems, wirings, pipes, sensors etc.). The present invention details linear support columns (B) which provide for modularity and ease of deployment of multiple collectors jointly connected by said support columns (B).

D2 discloses a pipe for carrying the thermal fluid out of the collector but, as disclosed, this pipe has only this purpose, whereas in the present invention it can also be a means for carrying electric connections.

As previously referred, the need for simple and effective terminations for the collector creates an additional challenge. D2 does not disclose any specific cushions or gaskets, these being absolutely essential for obtaining a working system. Furthermore, as the present invention makes use of multiple enclosures each associated with a collector, and does not make use of a single cover for multiple collectors, this creates special challenges to the collector terminations requiring proper thermal separation between absorber and enclosure, and between absorber and support structure. The present invention discloses a full working design, able to resolve these issues with the centrally placed weight bearing pipe (4), providing extremity terminations, comprised of thermal sleeves (e) and gaskets (f), cushions (b) and couplings (a), enabling the flow of thermal fluid or passage of electric connections, while at the same time bearing the weight of the absorber and its individual enclosure.

The present invention uses elliptical transparent tubes (2). D2 describes concave reflectors, which by nature cannot be transparent if they are to provide effective reflection. D2 uses parabolic reflectors, which in turn form a somewhat resembling but definitely not elliptical shape. D2 cover transparent elements are in reality flat, with no provision for any other format. The present invention makes use of the elliptical shape as to provide an effective transparent cover for the absorber surface, while at the same time providing for adequate structural bearing for the collector. The concave elements in D2 and the elliptical cover in the present invention are used for different functions, are different in their materials and even the actual shape is different.

Moreover, D2 only foresees using photovoltaic elements in the rear side of the absorber, while the present invention places them in direct solar energy absorption.
The previous points show how D2 describes a fundamentally different collector and support structure. The present invention provides elliptic transparent tubes housing individual collectors with effective side terminations and support structures. These features enable smaller and lighter collectors, facilitating installation and architectural acceptance, providing an effective shading and/or tile function, while allowing the substitution of construction elements (e.g. balconies safeguards). The present invention further allows straightforward progressive installation of collector modules and simple replacement of individual collectors.

Document EP 1 632 786 (subsequently referred as D3) refers to a Solar Tracker equipment, which is completely different from the present invention and is not suitable to be integrated architectonically on buildings. D3 claims a structure and means for effective solar tracking. The present invention, though able for solar tracking, accomplishes this in an essentially different way than D3, not by rotating the full structure, but by rotating individual collectors.

### Solar Receptors

Externally, these are formed by a transparent or translucent tube (2) of a circular, elliptical or other geometric form.

Depending on the use for which they are destined these may be either thermal or photovoltaic types. Both types can incorporate a Multifunction Blade (7), which permits them to be used as sunshades or tiles.

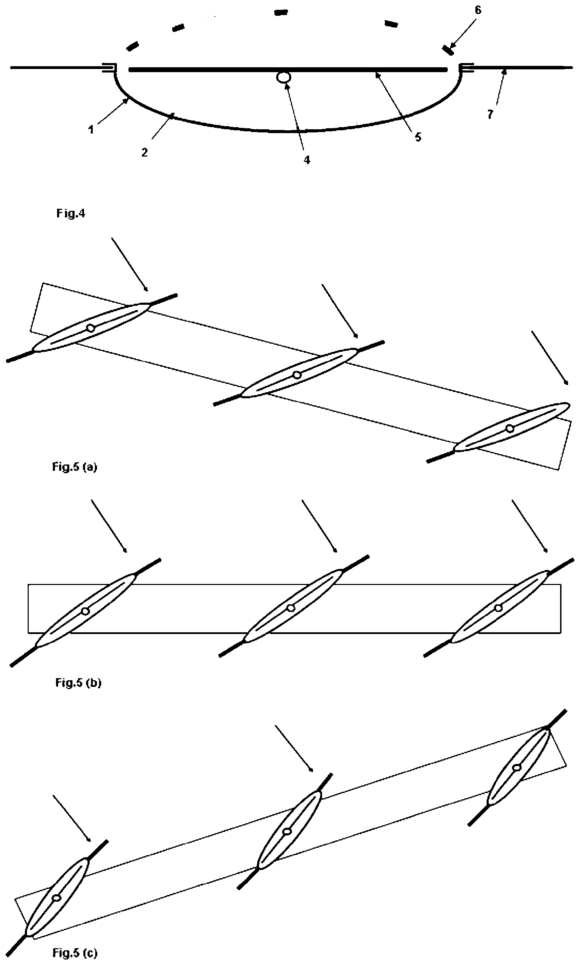

Fig 3 and 4 show the schematics of a thermal receptor and a photovoltaic receptor respectively.

The following is a description of the individual parts shown on figs 2, 3 and 4:

### Metallic Cover (1).

This metallic cover is installed on the back half of the receptor and supports the Multifunction Blade (7).

### External Tube (2)

On the thermal receptors this tube is mandatory and forms its external cover. It supports, protects and thermally isolates the internal parts form the exterior. This transparent tube is made of acrylic (PMMA) or other material which has the characteristics of being UV and weather resistant, has a low thermal conductivity and high transparency to infra red rays. Together with the two covers (8), it assures excellent thermal isolation (0.21WmK as opposed to 1,2 WmK for glass).

Note: The photovoltaic receptors may not have this external tube.

### Fixed internal pipe (3)

This copper pipe, which is in contact with the rotary internal pipe (4), ensures transmission of the heat into the fluid that flows internally.

Note: Photovoltaic receptors do not have this pipe.

### Rotating internal pipe (4)

In the thermal receptors only, this pipe transfers the heat collected from the sun through the "TiNOX selective coating".

The pipe is made from copper, welded and laminated to the coating and transfers heat by contact to the fixed internal pipe.

For the photovoltaic receptors the same pipe (in copper or another suitable material) supports the photovoltaic cells and carries the wiring from the receptors and then into the support columns.

Regardless of which type of receptor is being considered, it is this tube that permits the receptors to turn in the Teflon bushes

### Support blade (5)

This blade soldered to the rotary internal pipe (4) it is this that supports the Tinox ® "selective coating" (or alternative) or the photovoltaic cells.

### Position cells (6) and Microprocessor (9)

One set of five position sensing cells positioned in one of the external tubes (2) and a microprocessor (9) located in one of the technical support columns provide the information and calculations for tracking the sun in azimuth or latitude. The voltage in each of the silicon cells is compared and the values processed to give an error signal. The microprocessor analyses the deviation and drives the servo motor (11), the arm (10) and the rod (12) until symmetry is achieved.

For cloudy days, the microprocessor uses the last good data for a bright day or a predictive algorithm.

### Multifunction blade (7)

This blade is optional and can be fitted on either type of receptors. It has two distinct functions:
As a 'Sunshade' the blade is placed on either side of the metallic cover (1) and creates shadow to reduce the temperature of buildings, windows, car parks, etc. These blades overlap to produce shade without affecting the efficiency of the receptors.

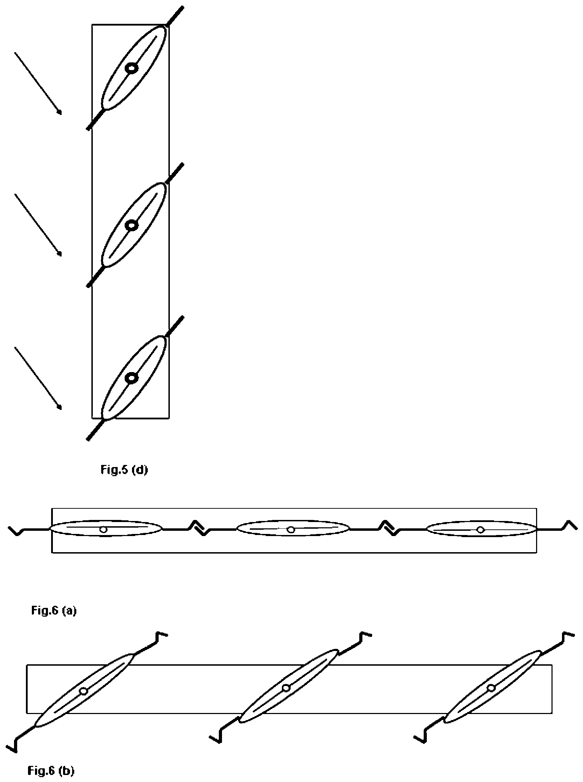

Alternatively the receivers can be mounted with a 'tile blade', which moves to a closed or open position (Fig 6.b) to protect the area underneath from the sun or rain. When precipitation occurs a moisture sensor located in the support columns sends information to the microprocessor, which automatically drives all the receptors to the closed position. If the rain stops, the receptors return to the normal solar position as calculated by the microprocessor. At night the solar receptors can be automatically sent to the closed position.

Note: Receptors equipped with either tiles or sunshades can be manually controlled to the preferred position.

### Covers (8)

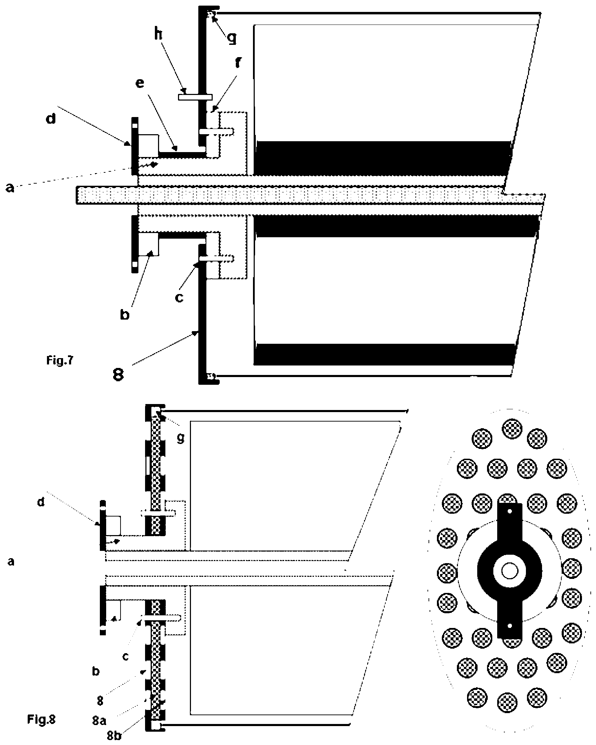

The tops of the receptors are closed by metal or plastic covers. For the thermal receptors, the thermal efficiency depends on the characteristics of this cover, which must ensure minimum internal losses. If a metal cover is used, it is also necessary to install a thermal rupture mechanism (fig 7.f) between the cover and the coupling box (fig 7.a). The covers also control the flow of heat within the receiver.

Fig 7. details the metallic cover assembly and other parts of a thermal receptor. These parts are:

### Coupling box (a).

This part is welded to the rotating internal pipe (fig 2, 3 (4)) and supports the cover (8).

### Cushion (b)

This is made of Teflon ® (with good thermal resistance and lubrication properties) and is represented in fig. 2 (13). It supports the coupling box (a), which rotates around it.

### Screws (c)

They fix the cover (8) to the coupling box (a).

### Arm (d)

Shown in fig 2 (10), the arm is responsible for the movement of the receptors. It is actuated by the rods (12) connected to the servo motor (11).

### Thermal sleeve (e)

This assures the thermal isolation of the coupling box (a).

### Thermal gasket (f)

This cork gasket thermal isolation of the receptor and the internal heat flows. Note that the cover cannot touch the coupling box directly.

### Relief valve (h)

In order to ensure good thermal isolation it is important to ensure that there are no thermal losses between the interior and exterior of the receiver, especially through any free air flow. As previously mentioned, the internal thermal isolation must be complete. On the other hand, the smaller the quantity of air inside the receptor, the less thermal loss, caused by convective air flow, will occur. By means of a natural process it is possible to minimize the quantity of air inside the receptors by installing a one-way valve in one cover. When the internal air temperature rises, the volume of air increases and some air is expelled through the valve. As the internal air temperature falls, the volume cannot decrease so the internal pressure reduces. The greater the difference between the two temperatures, the lower will be the internal pressure and the lower will be the internal losses in the receptor. In the winter, when the temperature is at a minimum, the receptor efficiency is maximized.

In the case of the photovoltaic receptors, the covers are of simpler construction as air may flow freely through them and they need no isolation.

Fig 8 shows a photovoltaic receptor with some common thermal receptor elements. Four elements have been omitted; the thermal sleeve (e); thermal gasket (f); relief valve (h) and the fixed internal pipe (3). Two new elements have been added; the dust filter (8a) and the new gasket with a hole in it.

The cover (8) and gasket (8b) ensure that the internal temperature is the same as ambient.

The gasket (8b) prevents dust from being deposited on the photovoltaic cells.

### Support columns (B)

The solar structure (fig 1 and 2) shows the support columns (B), which house the technical services. These columns form the supporting structure for both types of receptors and contain some of the elements necessary for driving them; servo motor (11); microprocessor (9); wiring, sensors and mechanical parts.

For the thermal receptors the support columns also contain the insulated pipes, safety valves, electro valves, air vents and pumps.

The support columns for the thermal receptors should have good internal insulation.

## Claims

1. A modular Multifunctional Solar Structure which can collect either thermal or photovoltaic energy from the sun; with a complimentary sunshade or tile function, placed at any solar position even in the vertical plane on building faces or at any other angle; comprising:
a variable number of thermal solar receptors composed of elliptical external transparent tubes with a solar tracking system comprising a microprocessor and photo sensitive cells to maintain them in a position perpendicular to the sun; supported at each extremity by a cushion (13), a cover (8), with a relief valve (h); all fixed to support columns containing the technical services; having an internal selective surface coated blade, which collects thermal energy; welded to the pipe (4) which transfers that energy by contact into a fixed pipe (3), a transfer fluid flows inside this pipe and carries the energy out through the said support columns (B) by means of insulated pipes (14); a variable number of photovoltaic solar receptors made with transparent elliptical external tubes with a photovoltaic blade a solar tracking system controlled by a microprocessor and photocells to maintain them perpendicular to the sun; supported at each extremity by a cushion, a cover, fixed to the said support columns (B);
**characterized in that** said support columns (B) house the technical services and comprise cushions (13) to support the receptors, a microprocessor (9) for electronic control, a servo motor (11) to activate the rods (12) and pipes or wires between the receptors and the other components.

2. A Modular Multifunctional Solar Structure, according to claim 1, wherein said thermal receptors and the photovoltaic receptors comprise an external transparent tube.

3. A Modular Multifunctional Solar Structure, according to claim 1, wherein said photovoltaic receptors are mounted without the external tube.

4. A Modular Multifunctional Solar Structure, according to claim 1, wherein said receptors comprise a multifunction blade on every exposed side.

5. A Modular Multifunctional Solar Structure, according to the previous claims comprising a relief valve in the thermal receptor.

## Patentansprüche

1. Eine modulare multifunktionstüchtige Solarstruktur, die sowohl thermale als auch photovoltaische Energie sammeln wann; mit einer zusätzlichen Sonnenblende oder Kachelfunktion, die an jeder Solarposition und sogar in der senkrechten Ebene auf den Gebäuden oder an jedem anderen Winkel gestellt; umfassend:
einer änderbaren Anzahl von thermalen Solarempfängern, zusammengesetzt aus elliptischen, externen, transparenten Röhren mit einer Solaranlage bestehend aus einem Mikroprozessor und photo-empfindlicher Zellen, um sie in einer senkrechten Position zur Sonne beizubehalten; unterstützt von einem Kissen (13) an jedes äußere Ende, einer Deckung (8), mit Überdruckventil (h); alle an Unterstützungssäulen befestigt, die technische Leistungen enthalten; die eine interne selektive oberflächliche, beschichtete Klinge haben, die thermale Energie sammelt; an das Rohr (4) geschweißt, das diese Energie durch Kontakt in ein befestigtes Rohr (3) überträgt, eine Übertragungsflüssigkeit fließt in dieses Rohr hinein und überbringt die Energie raus durch die genannten Unterstützungssäulen (B) mittels von isolierten Röhren (14); einer änderbaren Anzahl von photovoltaischen Solarempfängern gemacht mit transparenten, elliptischen, externen Röhren mit Photovoltaikklinge, einer Solaranlage, die von einem Mikroprozessor und Photozellen kontrolliert wird, um sie vertikal zur Sonne beizubehalten; unterstützt an jedes äußere Ende durch einen Kissen, einer Deckung, die an genannten Unterstützungssäulen (B) befestigt sind;
**gekennzeichnet dadurch, dass** genannte Unterstützungssäulen (B) die technischen Leistungen unterbringen und bestehend aus Kissen (13) zu Unterstützung der Empfänger, einem Mikroprozessor (9) zur elektronischen Kontrolle, einem Servomotor (11) zur Aktivierung der Stäbe (12) und Röhre oder Drahte zwischen den Empfängern und den anderen Komponenten.

2. Eine modulare multifunktionstüchtige Solarstruktur gemäß Anspruch 1, wobei genannte thermale Empfänger und die Photovoltaikempfänger aus einem externen, transparenten Rohr bestehen.

3. Eine modulare multifunktionstüchtige Solarstruktur gemäß Anspruch 1, wobei genannte Photovoltaikempfänger ohne ein externes Rohr gebaut sind.

4. Eine modulare multifunktionstüchtige Solarstruktur gemäß Anspruch 1, wobei genannte Empfänger aus einer multifunktionstüchtigen Klingel an jeder ausgestellten Seite bestehen.

5. Eine modulare multifunktionstüchtige Solarstruktur gemäß einer der vorigen Ansprüche umfassend ein Überdruckventil im thermalen Empfänger.

## Revendications

1. Structure solaire multifonctionnelle modulaire pouvant recueillir tant l'énergie photovoltaïque que thermique du soleil; dotée d'un pare-soleil complémentaire ou d'une fonction de tuile, placé sur toute position solaire même sur le plan vertical sur les façades de bâtiments ou sur tout autre angle; comprenant:
un nombre variable de récepteurs solaires thermiques composés de tubes transparents externes et elliptiques avec un système de traçage solaire, comprenant un microprocesseur et des cellules photosensibles pour les maintenir en position perpendiculaire au soleil; supporté sur chaque extrémité par un coussin (13), un couvercle (8), avec une soupape de sécurité (h); l'ensemble est fixé au colonnes de support contenant les services techniques; disposant d'une lame interne et sélective dont la surface est revêtue, recueillant de l'énergie thermique; soudé au tuyau (4) qui transfert cette énergie au contact d'un tuyau fixe (3), un fluide caloporteur coule à l'intérieur de ce tuyau et amène l'énergie à travers lesdites colonnes de support (B), au moyen de tuyaux isolés (14); un nombre variable de récepteurs solaires photovoltaïques fabriqués avec des tubes externes elliptiques et transparents, avec une lame photovoltaïque, un système de traçage solaire contrôlé par un microprocesseur et des photocellules afin de les maintenir perpendiculaires au soleil ; supporté sur chaque extrémité par une protection, un couvercle fixés aux dites colonnes de support (B);
**Caractérisé par le fait que** lesdites colonnes de support (B) hébergent les services techniques et comprennent les protections (13) pour soutenir les récepteurs, un microprocesseur (9) pour le contrôle électronique, un servomoteur (11) pour activer les barres (12) et les tuyaux ou les câbles entre les récepteurs et d'autres éléments.

2. Structure solaire multifonctionnelle modulaire, conformément à la revendication 1, où lesdits récepteurs thermiques et les récepteurs photovoltaïques comprennent un tube transparent externe.

3. Structure solaire multifonctionnelle modulaire, conformément à la revendication 1, où lesdits récepteurs photovoltaïques sont montés sans le tube externe.

4. Structure solaire multifonctionnelle modulaire, conformément à la revendication 1, où lesdits récepteurs comprennent un lame multifonction sur chaque côté exposé.

5. Structure solaire multifonctionnelle modulaire, conformément aux revendications antérieures, comprenant une soupape de sécurité au sein du récepteur thermique.
